# EUROPEAN PATENT SPECIFICATION

(11) **EP 1 085 575 B1**
(45) Date of publication and mention of the grant of the patent: **10.09.2008**
(21) Application number: 99830573.4
(22) Date of filing: 13.09.1999
(51) Int. Cl.: H01L 27/092, H01L 29/423, H03K 19/003

(54) **Electronic device for controlling the "bouncing" in electronic circuits integrated on semiconductor substrate**
Elektronisches Bauteil zur Regelung eines "Prelleffektes" in in einem Halbleitersubstrat integrierten elektronischen Schaltkreisen
Dispositif électronique de commande d'un effet de "rebonds" dans les circuits électroniques intégrés sur un substrat semi-conducteur

(43) Date of publication of application: 21.03.2001
(73) Proprietor: STMicroelectronics S.r.l., 20041 Agrate Brianza (Milano) (IT)
(72) Inventor: Imbruglia, Antonio, 95123 Catania (IT); Moscuzza, Sebastiano, 95045 Misterbianco (Catania) (IT); Airaksinen, Maria Leena, 95030 Tremestieri Etneo (Catania) (IT)
(74) Representative: Botti, Mario

(56) References cited:
- EP-A- 0 292 641
- US-A- 4 949 139
- US-A- 5 359 239
- PATENT ABSTRACTS OF JAPAN vol. 015, no. 108 (E-1045), 14 March 1991 (1991-03-14) -& JP 03 001571 A (TOSHIBA CORP), 8 January 1991 (1991-01-08)
- PATENT ABSTRACTS OF JAPAN vol. 008, no. 264 (E-282), 4 December 1984 (1984-12-04) -& JP 59 134869 A (NIPPON DENKI KK), 2 August 1984 (1984-08-02)

## Description

### Field of the Invention

This invention relates to an electronic device for controlling the "bouncing" in semiconductor integrated electronic circuits.

Specifically, the invention relates to an electronic device for controlling the "bouncing" in semiconductor integrated electronic circuits, which device comprises at least one MOS transistor output stage for supplying an external load.

The invention relates, particularly but not exclusively, to an electronic device for controlling the switching of outputs of CMOS electronic circuits integrated in a semiconductor, and the following description is made with reference to that field of application for convenience of explanation.

### Prior Art

As is well known, "bouncing" makes its appearance in integrated electronic circuits as certain digital output signals switch between two logic states.

These integrated circuits include final output stages, for each circuit output, and these final stages are essentially interface circuits provided for driving external loads.

The current design of integrated circuits operated at a low voltage requires an ever larger drive current I (e.g., of 24mA to 48mA per output) for the external loads.

The variation of this current, during the output signal switching, induces a voltage which follows the law V=LdI/dt and is due to the presence of inductive components L, attributable to parasites in the package itself and to the connecting cables. A typical value of this induced voltage would be around 500mV.

The significance of this voltage increases as several outputs are switched simultaneously in the integrated electronic circuit.

This is due to that, when one output of the integrated circuit switches over, the induced voltage at that output will affect the voltages at one or more of the adjacent outputs.

Then, after the outputs have switched over, the output voltage will be oscillating about its final value (i.e., bouncing) before it becomes settled at a voltage value corresponding to a high or a low logic state.

One method of minimizing this induced voltage consists of controlling the leading edge of the drive voltage, that is, the slew rate of the integrated circuit output stage.

A first prior technical solution consisted of dividing each final output stage into a plurality of parallel stages, all identical; these stages including active circuitry whereby the individual stages can be turned on sequentially. Thus, the switching edge of the current becomes offset or "stepped", and the current variation can be much smaller.

While being advantageous in more than one way, this first of the prior solutions has drawbacks, the control circuitry for these stages being, in fact, quite complicated.

A second prior technical solution is described in European Patent Application No. 0 678 983 by this Applicant.

This document discloses a circuit in which a current generator is used for controlling the leading edge of the drive current.

Although achieving its objective, this second of the prior solutions also involves a circuit arrangement which is fairly complicated and expensive to manufacture.

In the Japanese Application No. 03 001571 is disclosed a semiconductor device to smoothen variation in a drain current near the threshold value voltage by electrically connecting first and second source regions, first and second drain regions, first and second gate electrodes and varying the lengths of the of first and second gate electrodes.

In the US Patent N. 4,949,139 is disclosed a transistor construction for low noise output driver comprising parallel transistors with series - connected gate.

The technical problem that underlies this invention is to provide a final stage for an integrated circuit which is easily implemented and has structural and functional features effective to provide improved control of the output signal raising edges, thereby overcoming the limitations and drawbacks of prior art output stages.

### Summary of the Invention

The principle at the basis of the present invention is one of providing an output stage which comprises a MOS transistor having plural gate regions of different lengths for turning on the device sectionally.

Based on this principle, the technical problem is solved by a MOS device as previously indicated and defined in the characterizing part of Claim 1, and by a CMOS inverting stage as defined in the characterizing part of claim 5.
The features and advantages of a device according to the invention can be more clearly understood from the following description of an embodiment thereof, given by way of example and not of limitation with reference to the accompanying drawings.

### Brief Description of the Drawings

In the drawings:
Figure 1 is a schematic top plan view of an embodiment of the inventive device;

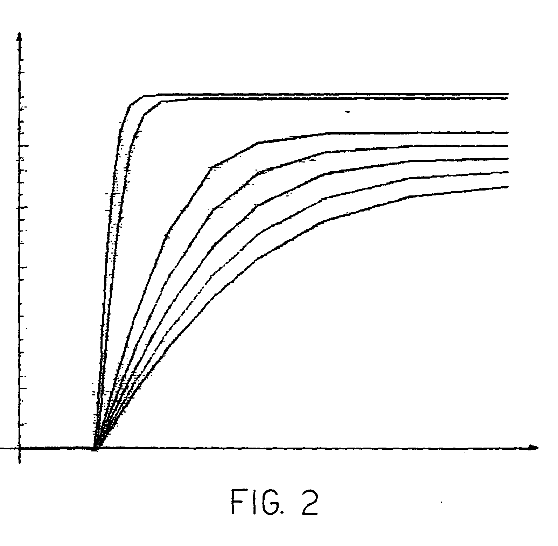

Figure 2 is a plot vs. time of the output voltages from different legs of the electronic device which embodies this invention.

### Detailed Description

Referring to the drawings figures, there is shown an output stage which comprises a CMOS inverting stage 1 integrated in a semiconductor substrate 10. This CMOS inverting stage 1 is formed of a P-type MOS transistor 2 (pull-up device) and an N-type MOS transistor 3 (pull-down device) which are connected in series between a first supply voltage reference VDD and a second voltage reference, e.g. a ground GND, of an integrated circuit. the final output stage 1 and is connected to interconnections pads.

According to the invention, the MOS transistor 2 has a plurality of "legs", each comprising a transistor 4. The transistors 4 are all connected in parallel together.

Each MOS transistor 4 has conventionally a drain region 5 and a source region 6. These regions 5, 6 are separated by a channel region overlaid by a gate region 7 which is isolated from the substrate 10 by means of an oxide layer.

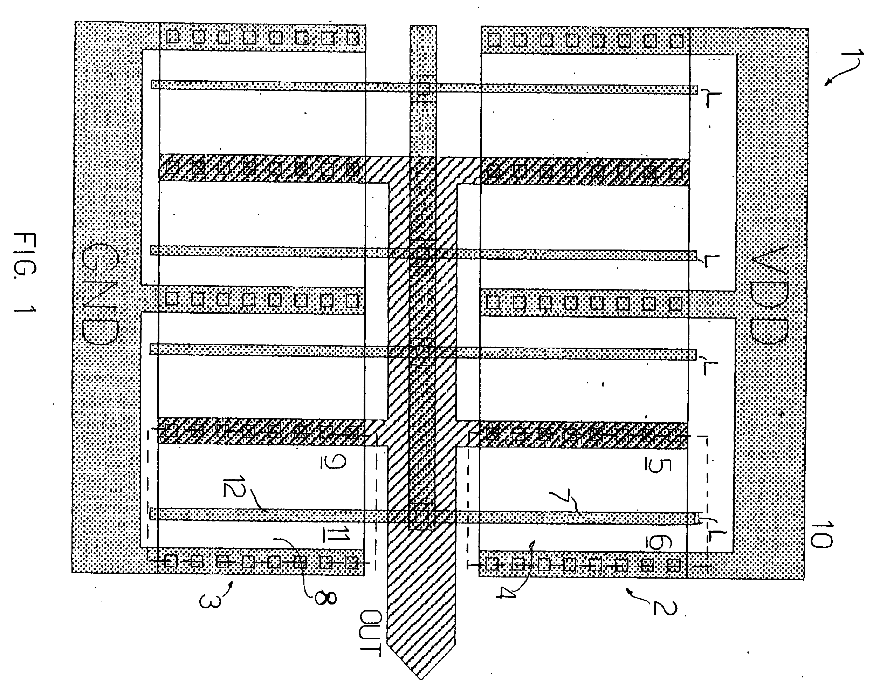

In the embodiment illustrated by Figure 1, four transistors 4 are shown connected in parallel together.

According to the invention, each of the transistors 4, which is comprised in transistor 2, has a channel region of different length L but the same width W.
The channel lengths have increasing values from 0.35µm to 0.6µm.

In view of that the turn-on resistance Ron of a MOS transistor is a function of the channel region length, by driving the gate regions of the transistors 4 with the same voltage, it becomes possible to turn on the various transistors 4 which are parts of the same transistor 2 sequentially.

This construction affords gradual switching of the output current. The output current is, in fact, increased gradually as the legs 4 of the transistor 2 are turned on in succession.

The MOS transistor 3 similarly has a plurality of "legs", each comprising a MOS transistor 8. These transistors 8 are connected in parallel together.

Each MOS transistor 8 has conventionally a drain region 9 and a source region 11. These regions 9, 11 are separated by a channel region overlaid by a gate region 12 which is isolated from the substrate 10 by means of an oxide layer.

In the embodiment illustrated by Figure 1, four such transistors 8 are shown connected in parallel together.

According to the invention, each of the transistors 8, which is comprised in transistor 3, has a channel region of different length L but the same width W. In a peculiarly advantageous embodiment, the channel lengths have increasing values from 0.35µm to 0.6µm.

The operation of the transistor 3, as driven by appropriate currents, is similar to that of the device 2 previously described.

To summarize, the electronic device 2, 3 of this invention enables the switching of the output drive current to be controlled by an arrangement having no need of a control logic in order to produce retarded turn-ons, which greatly simplifies the control logic.

## Claims

1. An electronic device for controlling the "bouncing" in electronic circuits integrated on a semiconductor (10), which device comprises at least one output stage for supplying an external load, and comprises, in said output stage, at least a transistor structure (2,3), connected between a voltage reference (VDD, GND) and an output node (OUT) and including a plurality of MOS transistors (4,8) that are all connected in parallel together, said MOS transistors (4,8) having channel regions of different channel lengths but a same width such that by driving gate regions of said MOS transistors (4,8) with a same voltage, they are turned on sequentially, and **characterized by** the channel lengths of said MOS transistors (4, 8) having increasing values from 0.35µm to 0.6µm.

2. An electronic device according to Claim 1, **characterized in that** said MOS transistors (8) are N-type transistors.

3. An electronic device according to Claim 1, **characterized in that** said MOS transistors (4) are P-type transistors.

4. An electronic device according to Claim 1, **characterized in that** said MOS transistors (4,8) are four.

5. CMOS inverting stage (1) integrated in a semiconductor substrate (10) comprising:
a P-type and an N-type MOS transistor structure (2,3) connected in series between a first supply voltage reference (VDD) and a second voltage reference (GND) and having a common output node (OUT),
said P-type MOS transistor structure (2) comprising a plurality of P-type transistors (4) that are connected in parallel together,
said N-type MOS transistor structure (3) comprising a plurality of N-typc transistors (8) that are connected in parallel together,
said P-type and N type MOS transistors (4, 8) having channel regions of different channel lengths but a same width such that by driving gate regions of said P-type and N-type MOS transistors (4,8) with a respective same voltage, they are turned on sequentially, and **characterized by** the channel lengths of said P-type and N-typc MOS transistors (4, 8) having increasing values from 0.35µm to 0.6µm.

6. An electronic device according to Claim 5, **characterized in that** said P-type and an N-type MOS transistor (4,8) are four.

## Patentansprüche

1. Elektronische Vorrichtung zur Regelung des "Prelleffektes" in auf einem Halbleiter (10) integrierten elektronischen Schaltungen, wobei die Vorrichtung mindestens eine Ausgangsstufe zum Speisen einer externen Last sowie in der Ausgangsstufe mindestens eine Transistorstruktur (2, 3) aufweist, die zwischen eine Spannungsreferenz (VDD, GND) und einen Ausgangsknoten (OUT) geschaltetet ist und eine Mehrzahl von MOS-Transistoren (4, 8), welche alle parallel zusammengeschaltet sind, beinhaltet, wobei die MOS-Transistoren (4, 8) Kanalbereiche unterschiedlicher Kanallängen, aber mit einer gleichen Breite aufweisen, so dass durch Ansteuern von Gate-Bereichen der MOS- Transistoren (4, 8) mit einer gleichen Spannung diese sequentiell eingeschaltet werden können,
**dadurch gekennzeichnet, dass** die Kanallängen der MOS-Transistoren (4, 8) ansteigende Werte von 0,35 µm bis 0,6 µm aufweisen.

2. Elektronische Vorrichtung nach Anspruch 1, **dadurch gekennzeichnet, dass** die MOS-Transistoren (8) Transistoren des N-Typs sind.

3. Elektronische Vorrichtung nach Anspruch 1, **dadurch gekennzeichnet, dass** die MOS-Transistoren (4) Transistoren des P-Typs sind.

4. Elektronische Vorrichtung nach Anspruch 1, **dadurch gekennzeichnet, dass** die MOS-Transistoren (4, 8) vier an der Zahl sind.

5. Eine auf einem Halbleiter-Substrat (10) integrierte CMOS-Invertierungsstufe (1), aufweisend:
eine P-Typ und eine N-Typ MOS-Transistorstruktur (2, 3), die in Reihe zwischen einer ersten Versorgungsspannungsreferenz (VDD) und eine zweite Spannungsreferenz (GND) geschaltet sind und einen gemeinsamen Ausgangsknoten (OUT) aufweisen,
wobei die P-Typ- MOS-Transistorstruktur (2) eine Mehrzahl von P-Typ-Transistoren (4) aufweist, die allesamt parallelgeschaltet sind,
wobei die N-Typ- MOS Transistorstruktur (3) eine Mehrzahl von N-Typ-Transistoren (8) aufweist, die allesamt parallelgeschaltet sind,
wobei die P-Typ und N-Typ MOS-Transistoren (4, 8) Kanalbereiche unterschiedlicher Kanallängen, aber mit einer gleichen Breite aufweisen, so dass durch Ansteuern von Gatebereichen der P-Typ- und N-Typ-MOS-Transistoren (4, 8) mit einer entsprechenden gleichen Spannung diese nacheinander eingeschaltet werden,
**dadurch gekennzeichnet, dass** die Kanallängen der P-Typ- und N-Typ-MOS Transistoren (4, 8) zunehmende Werte von 0,35 µm bis 0,6 µm aufweisen.

6. Elektronische Vorrichtung nach Anspruch 5, **dadurch gekennzeichnet, dass** die P-Typ- und N-Typ- MOS-Transistoren (4, 8) vier an der Zahl sind.

## Revendications

1. Dispositif électronique permettant de maîtriser le "rebond" dans des circuits électroniques intégrés sur un semiconducteur (10), ledit dispositif comprenant au moins un étage de sortie pour fournir une charge externe, et comprenant, dans ledit étage de sortie, au moins une structure de transistor (2, 3), connectée entre une référence de tension (VDD, GND) et un noeud de sortie (OUT) et incluant une pluralité de transistors MOS (4, 8) tous montés en parallèle, lesdits transistors MOS (4, 8) ayant des régions de canal présentant des longueurs de canal différentes mais une même largeur, de sorte qu'en commandant les régions de grille desdits transistors MOS (4, 8) avec une même tension, elles sont activées les unes à la suite des autres, et
**caractérisé en ce que** les longueurs de canal desdits transistors MOS (4, 8) ont des valeurs croissantes, de 0,35 µm à 0,6 µm.

2. Dispositif électronique selon la revendication 1, **caractérisé en ce que** lesdits transistors MOS (8) sont des transistors de type N.

3. Dispositif électronique selon la revendication 1, **caractérisé en ce que** lesdits transistors MOS (4) sont des transistors de type P.

4. Dispositif électronique selon la revendication 1, **caractérisé en ce que** lesdits transistors MOS (4, 8) sont au nombre de quatre.

5. Etage d'inversion CMOS (1) intégré dans un substrat semiconducteur (10) comprenant :
une structure de transistor MOS de type P et une structure de transistor MOS de type N (2, 3) montées en série entre une première référence de tension d'alimentation (VDD) et une deuxième référence de tension (GND) et ayant un noeud de sortie commun (OUT),
ladite structure de transistor MOS de type P (2) comprenant une pluralité de transistors de type P (4) qui sont montés en parallèle,
ladite structure de transistor MOS de type N (3) comprenant une pluralité de transistors de type N (8) qui sont montés en parallèle,
lesdits transistors de type P et de type N (4, 8) ayant des régions de canal présentant des longueurs de canal différentes mais une même largeur, de sorte que, en commandant les régions de grille desdits transistors MOS de type P et de type N (4, 8) avec une même tension respective, elles sont activées les unes à la suite des autres, et **caractérisé en ce que** les longueurs de canal desdits transistors MOS de type P et de type N (4, 8) ont des valeurs croissantes, de 0,35 µm à 0,6 µm.

6. Dispositif électronique selon la revendication 5, **caractérisé en ce que** lesdits transistors MOS de type P et de type N (4, 8) sont au nombre de quatre.
